**Europäisches Patentamt**

**European Patent Office**

**Office européen des brevets**

(19)

(11) Veröffentlichungsnummer : **0 523 325 B1**

(12) ## EUROPÄISCHE PATENTSCHRIFT

(45) Veröffentlichungstag der Patentschrift :
05.07.95 Patentblatt 95/27

(51) Int. Cl.⁶ : **G03F 7/28,** G03F 3/10

(21) Anmeldenummer : **92105968.9**

(22) Anmeldetag : **07.04.92**

(54) **Verfahren zur Herstellung von Bildern auf tonbaren lichtempfindlichen Schichten.**

(30) Priorität : **24.06.91 DE 4120793**

(43) Veröffentlichungstag der Anmeldung :
**20.01.93 Patentblatt 93/03**

(45) Bekanntmachung des Hinweises auf die
Patenterteilung :
**05.07.95 Patentblatt 95/27**

(84) Benannte Vertragsstaaten :
**FR GB IT**

(73) Patentinhaber : **E.I. DU PONT DE NEMOURS
AND COMPANY
1007 Market Street
Wilmington Delaware 19898 (US)**

(72) Erfinder : **Metzger, Bernhard, Dr.
Im Erlich 67
W-6100 Darmstadt (DE)**

(74) Vertreter : **Pistor, Wolfgang
Du Pont de Nemours (Deutschland) GmbH
Patentabteilung
Dornhofstrasse 10
D-63263 Neu-Isenburg (DE)**

## Beschreibung

Gegenstand der vorliegenden Anmeldung ist ein Verfahren zur Herstellung von Bildern auf tonbaren lichtempfindlichen Schichten, insbesondere zur Herstellung von Farbauszügen, unter Verwendung eines farbigen Übertragungsmaterials aus einem Schichtträger einer in ihrem Bindemittel ein feinteiliges Pulver oder ein feinteiliges Pulver und einen gelösten Farbstoff enthaltenden Übertragungsschicht und einer Deckschicht.

In der Reproduktionstechnik werden bekanntlich gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft, ob das spätere Druckergebnis eine tonwertrichtige Reproduktion der Vorlage darstellt.

Nach allgemeinen Standardvorschriften wird z.B. für einen hochwertigen Offsetdruck eine Auflösung von 2% - 98% Punkten - bei modernen Druckmaschinen sogar von 1% - 99% Punkten - bei einer Rasterweite von 60 Linien/cm gefordert, wobei es besonders schwierig ist, eine befriedigende Auflösung der spitzen 2% Punkte in den Lichtern und der 98% Punkte in den Schatten zu erreichen. Für eine gute Tonwertwiedergabe ist es ferner von erheblicher Bedeutung, daß Rasterpunkte gleicher Größe über den gesamten Flächenbereich scharf begrenzt und gleichmäßig, d.h. ohne Schwankungen in der Größe, wiedergegeben werden.

In solchen Farbprüfverfahren finden lichtempfindliche Aufzeichnungsmaterialien Verwendung, bei denen zur Bilderzeugung Unterschiede in der Klebrigkeit der belichteten und unbelichteten Bereiche der lichtempfindlichen Schicht ausgenutzt werden.

So ist z.B. aus den deutschen Patentschriften 12 10 321, 19 04 058, 19 04 059 und 20 04 214 und der US 4,356,253 und der EP-A 02 43 933 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen Photopolymerisationsinitiator enthält, durch bildmäßige Belichtung gehärtet wird, wobei die belichteten Bildteile ihre Klebrigkeit verlieren. Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden.

Negative Bilder der Vorlage erhält man, wenn man die z.B. in den deutschen Patentschriften 27 58 209, 30 23 247 und 34 29 615 beschriebenen lichtempfindlichen Materialien verwendet. Diese Aufzeichnungsmaterialien enthalten als lichtempfindliche Komponente entweder eine Dihydropyridinverbindung oder ein System aus einer Dihydropyridinverbindung und einer Hexarylbisimidazolverbindung.

Das Aufbringen der überwiegend aus feinteiligen Pulvern bestehenden Tonermaterialien kann durch Bestäuben der bildmäßig belichteten Oberfläche mit dem Toner erfolgen. Nach einer anderen Ausführungsform kann sich der Toner auch lose gebunden auf einem gesonderten Träger befinden und durch Inkontaktbringen dieses Trägers mit der bildmäßig belichteten Schicht übertragen werden.

Solche Übertragungsschichten sind wesentlich vorteilhafter, da ihre Handhabung erheblich einfacher, sauberer und umweltfreundlicher ist. Pigmentierte Übertragungsschichten sind z.B. in den deutschen Patentschriften 12 05 117 und 29 49 462 beschrieben. Diese Übertragungsschichten genügen jedoch nicht den hohen Anforderungen der Farbprüfverfahren. In DE-C 36 25 014, DE-C 37 06 528, DE-C 39 41 446 und DE-C 39 41 493 oder auch in EP-A 03 65 361 werden daher Farbprüfverfahren beschrieben, in denen spezielle, hierfür entwickelte Übertragungsschichten verwendet werden.

Zwar können mit diesen bekannten Verfahren die wichtigsten Anforderungen der Druckindustrie, wie hohe Auflösung, gute Tonwertwiedergabe und geringer Punktzuwachs, erfüllt werden. Jedoch ist das Problem des Hintergrundschleiers ("stain") noch nicht gelöst. Dieser Defekt beruht auf einer mehr oder weniger starken Übertragung der Farbpigmente der Übertragungsschicht auf die nicht klebrigen Bereiche des Aufzeichnungsmaterials, die eigentlich nicht getont werden sollen. Dieser Hintergrundschleier tritt insbesondere dann auf, wenn das lichtempfindliche Aufzeichnungsmaterial keine gute Differenzierung in der Klebrigkeit der belichteten und der unbelichteten Bereiche zeigt. Aber auch bei manchen der farbigen Übertragungsschichten tritt dieser Defekt verstärkt auf; insbesondere, wenn die Komponenten der Übertragungsschicht nicht optimal aufeinander abgestimmt sind. Durch veränderte Prozeßbedingungen bei der Herstellung und/oder bei der Verarbeitung, d.h. beim Laminierprozeß der Übertragungsschicht auf das Aufzeichnungsmaterial, kann der beschriebene Hintergrundschleier zwar verhindert werden, jedoch erfordert dies für jedes einzelne Material spezielle, technisch aufwendige und zeitintensive Maßnahmen.

Aufgabe der vorliegenden Erfindung ist es daher, ein Verfahren zur Herstellung von Bildern auf tonbaren lichtempfindlichen Schichten unter Verwendung einer mindestens ein feinteiliges Pulver oder ein feinteiliges Pulver und einen gelösten Farbstoff enthaltenden Übertragungsschicht anzugeben, mit dem die von der Druckindustrie geforderte hohe Auflösung von 1% - 99% Punkten erreicht werden kann, das sich durch eine hohe Gleichmäßigkeit der Rastertonwerte über die gesamte Fläche und einen sehr geringen Punktzuwachs auszeichnet, das für verschiedene tonbare lichtempfindliche Schichten und pigmentierte Übertragungsschichten anwendbar ist und das zudem Farbprüfdrucke liefert, die frei von störendem Hintergrundschleier sind.

Diese Aufgabe wird gelöst durch ein Verfahren zur Herstellung von Bildern bei dem

a) auf einer lichtempfindlichen Schicht durch bildmäßige Belichtung klebrige und nicht-klebrige Bereiche erzeugt werden,

b) die belichtete Schicht mit einer auf einem Schichtträger befindlichen Übertragungsschicht, die nicht lichtempfindlich ist und in ihrem Bindemittel mindestens ein feinteiliges Pulver oder mindestens ein feinteiliges Pulver und mindestens einen gelösten Farbstoff enthält, in Kontakt gebracht wird, und

c) die beiden Schichten getrennt werden, wobei die Übertragungsschicht nur an den klebrigen Bildbereichen haften bleibt.

Die Erfindung ist dadurch gekennzeichnet, daß die Übertragungsschicht auf ihrer vom Schichtträger abgewandten Oberfläche eine rauhe Deckschicht trägt.

Gegen den Einsatz der erfindungsgemäßen Übertragungsmaterialien in Farbprüfverfahren, bei denen eine hohe Auflösung, reproduzierbare Farbdichte und geringer Punktzuwachs gefordert sind, sprach, daß durch eine zusätzliche Deckschicht kein ausreichender Kontakt zwischen der farbigen Übertragungsschicht und den klebrigen, tonbaren Bereichen des Aufzeichnungsmaterials möglich sei. Solch unzureichender Kontakt führt dann durch ungenügende Farbübertragung zu Fehlstellen im endgültigen Bild. Besonders nachteilig wirkt sich ein schlechter Kontakt bei den spitzen 1-2% Punkten aus, da in diesem Bereich das Fehlen ganzer Punkte auftreten kann.

Überraschend wurde aber festgestellt, daß die erfindungswesentlichen Übertragungsmaterialien Farbprüfdrucke mit ausgezeichneter Qualität liefern und Fehlstellen in den Bildbereichen nicht auftreten.

Die erfindungsgemäßen Übertragungsmaterialien weisen aber gegenüber den herkömmlichen Materialien den besonderen Vorteil auf, daß die mit ihnen hergestellten Farbprüfdrucke keinen störenden Hintergrundschleier aufweisen. Der Hintergrundschleier wird bestimmt mittels der Farbwertdifferenz $\Delta E$ zwischen Nichtbildbereichen, die während des Tonungsvorgangs abgedeckt waren, und solchen Nichtbildbereichen, die während des Tonungsprozesses mit der Übertragungsschicht in Kontakt waren. Mit den Materialien des Standes der Technik werden hierbei meist $\Delta E$-Werte von 0,5-0,7 erreicht, was einem nicht tolerierbaren Hintergrundschleier entspricht. Als Höchstgrenze ist ein $\Delta E$-Wert von 0,45 möglich. Bevorzugt sollte $\Delta E$ jedoch unter 0,3 liegen. Mit den erfindungsgemäßen Übertragungsschichten werden $\Delta E$-Werte von ca. 0,2 erreicht. Der Herstellungsprozeß der neuen Übertragungsmaterialien ist zudem trotz eines zusätzlichen Verfahrensschrittes zum Aufbringen der Deckschicht einfacher und liefert Produkte von gleichbleibend hoher Qualität. Ein weiterer Vorteil des erfindungsgemäßen Verfahrens ist, daß an die tonbaren Aufzeichnungsmaterialien keine speziellen Anforderungen, insbesondere bezüglich ihrer Klebrigkeitsdifferenz zwischen belichteten und nicht belichteten Bereichen, gestellt werden. So ist das neue Übertragungsmaterial mit einer Vielzahl von tonbaren lichtempfindlichen Materialien kombinierbar.

Das lichtempfindliche Material kann sowohl aus positiv als auch aus negativ tonbaren Systemen bestehen, wie sie in DE-C 12 10 321, DE-C 19 04 058, DE-C 19 04 059 und DE-C 20 04 214 bzw. DE-C 27 58 209, DE-C 30 23 247 und DE-B 34 29 615 beschrieben werden. Bevorzugt werden positive, lichtempfindliche Materialien verwendet wie sie z.B. in der US 4,356,253 und in der EP-A 02 43 933 beschrieben sind.

Zur Durchführung dieses Übertragungsverfahrens ist außerdem kein besonders geschultes Personal notwendig, da eine aufwendige Abstimmung aller Verfahrensparameter auf die jeweils verwendeten tonbaren Aufzeichnungs- und/oder farbigen Übertragungsmaterialien entfallen kann. Auch bei nicht optimal eingestellten Verfahrensbedingungen werden Farbprüfdrucke ausgezeichneter Qualität erhalten.

Die erfindungswesentliche Deckschicht enthält mindestens ein Bindemittel und diskrete, inerte Teilchen. Insbesondere rauhe Deckschichten, die im wesentlichen aus diskreten, inerten Teilchen bestehen, die bevorzugt farblos sind, sind geeignet. Bevorzugt weisen diese Teilchen einen Durchmesser von $\leqq 15\ \mu m$ auf. Besonders bevorzugt sind Teilchen mit einem Durchmesser von $\leqq 5\ \mu m$.

Die Teilchen der rauhen Deckschicht können sowohl aus anorganischem wie auch aus organischem Material bestehen. Geeignet sind Materialien wie Siliciumdioxid, Zinkoxid, Titanoxid Zirkonoxid, Aluminiumoxid, Stärke, Phenolharze oder Homo- und Copolymere aus Styrolen, Vinylalkoholen, Vinylacetaten, Acrylsäure und Methacrylsäure oder deren Derivaten und Tetrafluorethylen. Besonders geeignet sind Homo- und Copolymere ungesättigter Kohlenwasserstoffe wie Ethylen und Propylen.

Die Auftragsmenge der erfindungswesentlichen diskreten, inerten Teilchen beträgt bevorzugt 0,5-5 000 Teilchen/mm$^2$. Besonders bevorzugt ist eine Auftragsmenge von 10-500 Teilchen/mm$^2$, insbesondere 50-200 Teilchen/mm$^2$. Die erfindungsgemäße rauhe Deckschicht kann auch ein geeignetes Bindemittel enthalten, bevorzugt 80 Gew.%, besonders bevorzugt 30 bis 70 Gew.%. Geeignete Bindemittel sind z.B. die in DE-C 36 25 014, DE-C 39 41 446 oder DE-C 39 41 493 beschriebenen Bindemittel für die farbigen Übertragungsmaterialien. Besonders geeignet sind Polymere mit einer max. Zugspannung von $\geqq$ 2 N/mm$^2$ wie sie in DE-C 39 41 493 beschrieben werden. Bevorzugt werden aber Deckschichten ohne Bindemittel bevorzugt. Das Aufbringen der Deckschicht auf die farbige Übertragungsschicht kann durch verschiedene Verfahren erfolgen. Das die Deckschicht bildende Material kann z.B. durch Aufstäuben feiner Pulver aufgebracht werden oder durch Vergießen, Verdrucken bzw. Versprühen von Dispersionen der Pulver in geeigneten Lösungsmitteln. Zusätze wie z.B. Netzmittel, Gießhilfsmittel, etc. können verwendet werden. Nach dem Trocknen sind die so hergestellten Materialien sofort verarbeitbar.

Als farbige Übertragungsschicht können alle bekannten Materialien verwendet werden, wie z.B. die in DE-C 36 25 014, DE-C 39 41 446, DE-C 39 41 493 bzw. EP-A 03 65 361 beschriebenen Schichten. Besonders geeignet sind die Materialien der DE-C 39 41 493, die als Bindemittel Polymere mit einer maximalen Zugspannung von $\geqq$ 2 N/mm$^2$, bevorzugt zwischen 2 und 110 N/mm$^2$ besitzen. Besonders geeignet sind Polymere, deren maximale Zugspannung zwischen 5 und 60 N/mm$^2$ liegt.

Als Beispiel für diese Polymere seien genannt: Homo- und Copolmyere aus Ethylen, Propylen, Vinylestern, Vinylchlorid, Acrylaten, Methacrylaten und Acrylamiden bzw. Methacrylamiden und Cellulosederivate. Besonders geeignet sind Polymere, die in organischen Lösungsmitteln löslich sind. Insbesondere Copolymere aus Vinylacetat und Ethylen und Polymethylmethacrylate oder Polystyrole sind hervorragend geeignet.

Die Übertragungsschicht sollte $\geqq$ 20 Gew.-% eines feinteiligen Pulvers oder der Kombination feinteiliges Pulver/gelöster Farbstoff enthalten, bevorzugt 30-70 Gew.-%.

Besonders bevorzugt sind Übertragungsmaterialien, die das Bindemittel und das feinteilige Pulver - z.B ein Pigment - in ungefähr gleichen Mengen enthalten.

Zur Bildaufzeichnung geeignete feinteilige Pulver sind aus der Literatur, beispielsweise aus der DE-C 19 04 059 und der DE-C 29 46 896, in großer Zahl bekannt. Bei diesen Pulvern handelt es sich überwiegend um Pigmente, jedoch sind auch gelöste Farbstoffe in Kombination mit einem feinteiligen Pulver brauchbar. Als Beispiele seien genannt: anorganische und organische Pigmente, Leuchtstoffe, Metallpulver in reiner Form oder zusammen mit einem pulverförmigen organischen oder anorganischen Träger, wie Titandioxyd, Glaspulver, Kohlenstoff (Ruß oder Graphit), Metall-Phthalocyanine, Azofarbstoffe, Metallpulver aus Aluminium, Kupfer, Eisen, Gold oder Silber oder Metalloxyde. Besonders vorteilhaft ist die Verwendung einer Mischung aus Pigment und SiO$_2$. Die Herstellung der Beschichtungsmasse erfolgt nach bekannten Methoden.

Zur Herstellung der Übertragungsschicht wird die Beschichtungsmasse nach bekannten Methoden auf einen geeigneten Schichtträger aufgetragen und anschließend getrocknet. Bevorzugt werden die Pigment/Bindemittel Mischungen aus organischen Lösungsmitteln auf die Schichtträger aufgebracht.

Geeignete Schichtträger sind insbesondere Papier und Kunststoffolien aus Polyestern, Polyamiden, Polyethylen, Polypropylen, Polyvinylchlorid und dergleichen. Besonders vorteilhaft sind kompressible Materialien, wie sie in der DE-C 37 06 528 beschrieben werden.

Die Dicke der getrockneten Schicht kann bis zu 8 $\mu$m betragen, bevorzugt bis zu 5 $\mu$m. Besonders bevorzugt sind sehr dünne Schichten mit einer Dicke < 3 $\mu$m bevorzugt 0,4 - 1,5 $\mu$m.

Außer den bereits genannten Bestandteilen kann die Beschichtungsmasse noch andere Zusätze, wie Netzmittel, Gießhilfsmittel, Gleitmittel, Mittel zur Erhöhung der Viskosität, Mittel zur Haftungskontrolle und dergleichen enthalten.

Das erfindungsgemäße Verfahren kann mit Vorteil zur Wiedergabe von Strich- und Rasteraufnahmen für die Anwendung im graphischen und sonstigen industriellen Bereichen, zur Herstellung von Landkarten, Werbedrucken, Plakaten, Leuchtschriften und zur Herstellung gedruckter Schaltungen verwendet werden.

Das Hauptanwendungsgebiet liegt jedoch in der Herstellung von Ein- oder Mehrfarbenbildern und in der Verwendung für Farbprüfverfahren.

Die Durchführung eines Farbprüfverfahrens gemäß der vorliegenden Erfindung umfaßt die folgenden Verfahrensschritte:

Das lichtempfindliche Material z.B. ein Laminat aus einer auf eine Trägerfolie aufgetragenen photopolymerisierbaren Schicht mit einer Deckfolie wird nach Entfernung der Deckfolie auf ein Bildempfangsmaterial aufgebracht und durch den transparenten Schichtträger hindurch, je nach dem ob es sich um ein positiv oder negativ arbeitendes System handelt, unter Verwendung eines gerasterten Farbauszugs-Positivs oder -Negativs einer ersten Farbe als Vorlage mit aktinischer Strahlung zur Ausbildung von klebrigen und nicht klebrigen Bereichen belichtet.

Die lichtempfindlichen Materialien besitzen ihre maximale Empfindlichkeit im Ultraviolettbereich, bevorzugt im Wellenlängenbereich zwischen 250 und 450 nm. Zur Belichtung sind daher alle Strahlungsquellen geeignet, die eine wirksame Menge dieser Strahlung liefern, beispielsweise Xenonlampen, Quecksilberdampflampen und Kohlebogenlampen, Laser, Fluoreszenzlampen mit UV-Strahlung emittierenden Leuchtstoffen und Elektronenblitzgeräte.

Nach dem Entfernen des Schichtträgers wird die Übertragungsschicht mit der erfindungsgemäßen Deckschicht auf die belichtete Schicht auflaminiert und wieder abgezogen. Man erhält ein gefärbtes Bild der Vorlage. Ein zweites Laminat des lichtempfindlichen Materials wird nach Entfernung der Deckfolie auf das Bild auflaminiert und unter gleichen Bedingungen durch ein gerastertes Farbauszugs-Negativ oder - Positv einer zweiten Farbe als Vorlage belichtet und durch Auflaminieren und wieder Abziehen der Übertragungsschicht mit der erfindungsgemäßen Deckschicht getont.

Dieser Vorgang wird dann für einen Farbauszug einer dritten Farbe und falls erwünscht, für einen Schwarzauszug wiederholt. Man erhält ein den Vorlagen entsprechendes farbiges Bild.

Ein besonderer Vorteil des erfindungsgemäßen Verfahrens besteht darin, daß man, ausgehend von einem positiv arbeitenden lichtempfindlichen System, auch mit negativen Farbauszügen als Vorlage 4-farbige Overlays und daraus einen positiven Farbprüfdruck herstellen kann.

Wird von negativen Farbauszügen ausgegangen, so wird zunächst ein Prüfdruck nach der oben angegebenen Verfahrensweise hergestellt. Die auf den für die Übertragung der Teilfarben verwendeten Übertragungsschichten verbleibenden Restbilder werden dann zur Herstellung des Prüfdruckes unter Verwendung von klebenden Zwischenschichten, unter Anwendung von Druck und/oder Wärme und nachfolgendem Abzug des Schichtträgers übereinander laminiert.

Nach einer anderen Ausführungsform ist es jedoch auch möglich, die auf den Übertragungsschichten verbleibenden Restbilder als Overlay übereinander zu legen.

Die nachfolgenden Beispiele sollen die Erfindung veranschaulichen.

Die angegebenen Teile und Prozente beziehen sich, falls nichts anderes angegeben ist, auf das Gewicht.

Beispiel 1

Zur Herstellung einer erfindungsgemäßen Übertragungsschicht wurden 3,34 g Ethylen-Vinylacetat Copolymer (40% Vinylacetat, maximale Zugspannung 5,3 N/mm$^2$ gemäß ASTM D-882),8,83 g Nitrocellulose (Stickstoffgehalt <12,6%), 4,3 g Cyan-Pigment auf Kupferphthalocyaninbasis (C.I. 74160) und 0,2 g Netzmittel mit der Hälfte eines Lösungsmittelgemischs aus Toluol, Methylethylketon und Xylol (60:35:5, insgesamt 83,3 g) in einer Perlmühle gemahlen. Anschließend wurde unter starkem Rühren das restliche Lösungsmittel zugegeben. Die Beschichtungsmasse wurde dann auf eine 60 μm dicke Polypropylen-Schaumfolie gemäß DE-OS 37 06 528 aufgetragen, daß nach dem Trocknen eine 0,45 μm dicke Schicht erhalten wurde. Nach dem Trocknen wurde auf die Übertragungsschicht eine 20%ige Dispersion eines Polyethylenwachses (Teilchengröße ≦ 1 μm) in Xylol aufgebracht. Die Auftragsmenge betrug 100-200 Teilchen/mm$^2$.

Zur Herstellung des Farbbildes wurde eine gemäß den Angaben von Beispiel 1 der EP-A 02 43 933 hergestellte, positiv tonbare, photopolymerisierbare Schicht nach Entfernung der Deckfolie auf ein Bildempfangsmaterial auflaminiert und durch einen gerasterten Cyan-Farbauszug in einem Vakuumkopierrahmen mit einer Metallhalogenidlampe (3 000 W) unter Verwendung eines UV-Filters 42s im Abstand von 95 cm belichtet. Nach Entfernung des Schichtträgers wurde das Tonermaterial enthaltende Übertragungsmaterial auf die bildmäßig belichtete Schicht auflaminiert und sofort wieder abgezogen. Die Übertragungsschicht blieb nur auf den unbelichteten, klebrigen Stellen haften, und man erhielt ein positives Cyanbild der Vorlage mit einer Auflösung von 1% - 99% Rasterpunkten im 60-Linien/cm-Raster. Zur Bestimmung des Hintergrundschleiers wurde ein Teil der nicht zu tonenden Bildbereiche vor dem Tonungsvorgang mit einer Polyesterfolie abgedeckt.

Anschließend wurde gemäß DIN 5033 die Farbwertdifferenz Δ E zwischen abgedeckten und nicht abgedeckten Bereichen ermittelt. Δ E betrug ca. 0,2 und das Bild zeigte somit keinen störenden Hintergrundschleier.

Beispiel 2

Gemäß den Angaben in Beispiel 1 wurde eine 0,45 μm dicke Übertragungsschicht ohne Deckschicht hergestellt und verarbeitet.

Bei den in diesem Beispiel verwendeten, nicht erfindungsgemäßen Übertragungsmaterialien war der Hintergrundschleier zu hoch (Δ E = 0,6).

Beispiel 3

Die zur Herstellung eines Vierfarbbildes benötigten Übertragungsmaterialien der Farben Cyan, Magenta, Gelb und Schwarz wurden hergestellt, indem man die in der Tabelle 1 angegebenen Mengen Pigment, Bindemittel und Netzmittel in einer Perlmühle mit 40 bis 60% des insgesamt benötigten Lösungsmittelgemisches aus Toluol, Methylethylketon und Xylol (6:3:1) mahlte. Anschließend wurde unter starkem Rühren das restliche Lösungsmittel zugeben.

EP 0 523 325 B1

Tabelle 1

|  | CYAN(g) | MAGENTA(g) | GELB(g) | SCHWARZ(g) |
|---|---|---|---|---|
| Pigment | 52,50 | 80 | 35,0 | 50 |
| amorphes $SiO_2$ | 15,00 | 50 | 8,0 | 40 |
| Ethylenvinylacetat Copolymer 18% Vinylacetat, max. Zugspannung: 5,9 $N/mm^2$ gemäß ASTMD-882 | 80,55 | 116,75 | 56,0 | 107,4 |
| anionisches Netzmittel | 1,95 | 3,25 | 1,0 | 2,6 |
| Lösungsmittel | 850,0 | 750,0 | 900,0 | 800,0 |

Als Pigmente wurden für die Cyan-Übertragungsschicht a) eine Mischung eines Cyan-Pigments auf Kupferphthalocyaninbasis (C.I. 74160) und eines Magenta-Pigments (C.I. Pigment Red 123), für die Magenta-Übertragungsschicht b) ein Gemisch zweier Magenta-Pigmente (C.I. Red 122 und Pigment Red 123) und für die Gelbübertragungsschicht c) das Farbpigment (C.I. Pigment Yellow 117) verwendet. Die Übertragungsschicht für Schwarz d) enthielt C.I. Pigment Black 7. Die Beschichtungsmasse wurde mit einem 80 Linien/cm Linienraster mit einer Druckgeschwindigkeit von 150 m/min im direkten Gravurdruck auf eine 60 μm dicke Polypropylenschaumfolie gemäß DE-OS 37 06 528 aufgedruckt. Nach dem Trocknen wurde auf die 1 μm dicke Schicht eine 20%ige Dispersion eines Polyethylenwachses (Teilchengröße $\leq$ 1 μm) in Xylol aufgebracht. Die Auftragsmenge betrug 100-200 Teilchen/$mm^2$. Die Farbdichte der einzelnen Schichten betrug:

Cyan: 1,30
Magenta: 1,40
Gelb: 1,30
Schwarz: 1,70

Zur Herstellung eines Vierfarben-Prüfdruckes wurde eine gemäß den Angaben von Beispiel 1 der EP-A 02 43 933 hergestellte, positiv tonbare photopolymerisierbare Schicht nach Entfernung der Deckfolie auf ein Bildempfangsmaterial auflaminiert und durch einen gerasterten positiven Cyan-Farbauszug in einem Vakuumkopierrahmen mit einer Metallhalogenidlampe (3 000 Watt) unter Verwendung eines Ultraviolett-Filters 42s im Abstand von 95 cm belichtet. Nach Entfernung des Schichtträgers wurde das Übertragungsmaterial a) auf die bildmäßig belichtete Schicht auflaminiert und sofort wieder abgezogen. Die Übertragungsschicht blieb nur auf den unbelichteten, klebrigen Stellen haften, und man erhielt ein positives Cyanbild der Vorlage ohne störenden Hintergrundschleier.

Eine zweite Schicht des positiven tonbaren photopolymerisierbaren Aufzeichnungsmaterials wurde auf das Cyanbild auflaminiert und wie oben durch den entsprechenden gerasterten Magenta-Farbauszug belichtet. Nach Entfernung des Schichtträgers wurde das Übertragungsmaterial b) auf die bilmäßig belichtete Schicht auflaminiert und wieder abgezogen. Die Übertragungsschicht bleibt nur an den unbelichteten klebrigen Stellen haften, und man erhielt ein positives Magenta-Bild ohne störenden Hintergrundschleier. Für die Farben Gelb und Schwarz wurden die Arbeitsschritte entsprechend wiederholt und anschließend in üblicher Weise eine Schutzschicht aufgebracht. Man erhielt einen Vierfarben-Prüfdruck von ausgezeichneter Brillianz und Schärfe mit einer Auflösung von 1% - 99% im 60-Linien/cm - Raster, der eine naturgetreue Wiedergabe des Originals darstellt. Die Punktzuwächse lagen bei allen vier Farben um 19% im Mitteltonbereich. Der Prüfdruck zeigt keinen störenden Hintergrundschleier (Δ E ca. 0,2).

**Patentansprüche**

1. Verfahren zur Herstellung von Bildern bei dem
   a) auf einer lichtempfindlichen Schicht durch bildmäßige Belichtung klebrige und nicht-klebrige Bereiche erzeugt werden,
   b) die belichtete Schicht mit einer auf einem Schichtträger befindlichen Übertragungsschicht, die nicht

6

lichtempfindlich ist und in ihrem Bindemittel mindestens ein feinteiliges Pulver oder mindestens ein feinteiliges Pulver und mindestens einen gelösten Farbstoff enthält, in Kontakt gebracht wird, und
c) die beiden Schichten getrennt werden, dadurch gekennzeichnet, daß die Übertragungsschicht auf ihrer vom Schichtträger abgewandten Oberfläche eine rauhe Deckschicht trägt.

2. Verfahren zur Herstellung von Mehrfarbenbildern bei dem
a) auf einem Bildträger eine lichtempfindlichen Schicht aufgebracht wird, in der durch bildmäßige Belichtung klebrige und nicht-klebrige Bereiche erzeugt werden können,
b) die lichtempfindliche Schicht bildmäßig belichtet wird,
c) die belichtete Schicht mit einer auf einem Schichtträger befindlichen Übertragungsschicht, die nicht lichtempfindlich ist und in ihrem Bindemittel mindestens ein feinteiliges Pulver oder mindestens ein feinteiliges Pulver und mindestens einen gelösten Farbstoff enthält, in Kontakt gebracht wird,
d) der Schichtträger mit den nicht haftenden Bereichen der Übertragungsschicht wieder entfernt wird und
e) die Schritte a - d mehrfach wiederholt werden, wobei unter a) die neue lichtempfindliche Schicht auf die gemäß den vorhergehenden Schritten behandelte lichtempfindliche Schicht aufgebracht wird,
dadurch gekennzeichnet, daß
die Übertragungsschicht auf ihrer vom Schichtträger abgewandten Oberfläche eine rauhe Deckschicht trägt.

3. Verfahren nach Anspruch 1 oder 2,
dadurch gekennzeichnet, daß
die rauhe Deckschicht im wesentlichen aus diskreten, inerten Teilchen besteht.

4. Verfahren nach Anspruch 3,
dadurch gekennzeichnet, daß
die Teilchen der Deckschicht einen Durchmesser von $\leqq$ 15 $\mu$m aufweisen.

5. Verfahren nach Anspruch 3 oder 4,
dadurch gekennzeichnet, daß
die Auftragsmenge der diskreten, inerten Teilchen 0,5-5 000 Teilchen/mm$^2$ beträgt.

6. Verfahren nach Anspruch 1 bis 5,
dadurch gekennzeichnet, daß
die Teilchen der Deckschicht aus $SiO_2$, $Al_2O_3$ und/oder Homo- und/oder Copolymeren von Ethylen, Propylen oder Acrylsäure bzw. Methacrylsäure und ihren Derivaten bestehen.

7. Verfahren nach Anspruch 1 bis 6,
dadurch gekennzeichnet, daß
die Deckschicht $\leqq$ 80 Gew.% eines Polymeren mit einer max. Zugspannung von $\geqq$ 2 N/mm$^2$ enthält.

8. Verfahren nach Anspruch 1 bis 7,
dadurch gekennzeichnet, daß
die Übertragungsschicht 30 - 70 Gew.% der feinteiligen Pulver oder der Kombination feinteiliges Pulver/gelöster Farbstoff enthält.

9. Verfahren nach Anspruch 1 bis 8,
dadurch gekennzeichnet, daß
die Übertragungsschicht mindestens ein Polymer mit einer maximalen Zugspannung von $\geqq$ 2 N/mm$^2$ enthält.

10. Verfahren nach Anspruch 1 bis 9,
dadurch gekennzeichnet, daß
der Schichtträger aus einem kompressiblen Material besteht.

11. Verfahren nach Anspruch 1 bis 10,
dadurch gekennzeichnet, daß
als tonbare lichtempfindliche Schicht eine photopolymerisierbare Schicht verwendet wird, die mindestens ein photopolymersierbares Monomeres, einen Photoinitiator und ein Bindemittel enthält.

**Claims**

1. Process for the preparation of images comprising
   a) producing tacky and non-tacky areas on a light-sensitive layer by imagewise exposure,
   b) contacting the exposed layer with a transfer layer on a support, said transfer layer being light-insensitive and having at least one finely divided powder or at least one finely divided powder and at least one dissolved dye in its binder, and
   c) separating these two layers,
   characterized in that
   the transfer layer has a rough cover layer on its surface away from the support.

2. Process for the preparation of multicolor images comprising
   a) applying onto a support a light-sensitive layer in which tacky and non-tacky areas can be produced by imagewise exposure,
   b) exposing the light-sensitive layer imagewise,
   c) contacting the exposed layer with a transfer layer on a support, said transfer layer being light-insensitive and having at least one finely divided powder or at least one finely divided powder and at least one dissolved dye in its binder, and
   d) removing the support with the non-adhering areas of the tranfer layer, and
   e) repeating steps a) - d) several times , whereby in step a) the new light-sensitive layer is applied onto the light-sensitive layer treated according to the preceding steps
   characterized in that
   the transfer layer has a rough cover layer on its surface away from the support.

3. Process according to claim 1 or 2,
   characterized in that
   the rough cover layer consists essentially of discrete, inert particles.

4. Process according to claim 3,
   characterized in that
   the discrete, inert particles have a diameter of $\leqq 15$ microns.

5. Process according to claim 3 or 4,
   characterized in that
   the discrete, inert particles are present in the amount of 0.5 - 5000 particles/mm$^2$.

6. Process according to claims 1 - 5,
   characterized in that
   the particles of the cover layer consists of $SiO_2$, $Al_2O_3$, and/or homo- and/or copolymers of ethylene, propylene, acrylic acid, or methacrylic acid or their derivatives.

7. Process according to claims 1 - 6,
   characterized in that
   the cover layer contains $\leqq 80\%$ by weight of polymer having a tensile strength of $\geqq 2$ N/mm$^2$.

8. Process according to claims 1 - 7,
   characterized in that
   the transfer layer contains 30 - 70% by weight of a finely divided powder or a combination of a finely divided powder and a dissolved dye.

9. Process according to claims 1 - 8,
   characterized in that
   the transfer layer contains at least one polymer having a tensile strength of $\geqq 2$ N/mm$^2$.

10. Process according to claims 1 - 9,
    characterized in that
    the support is a compressible material.

11. Process according to claims 1 - 10,

EP 0 523 325 B1

characterized in that
the tonable, light-sensitive layer is a photopolymerizable layer containing at least one photopolymerizable monomer, one photoinitiator, and one binder.

## Revendications

1. Procédé d'obtention d'images dans lequel:
   (a) on obtient des zones collantes et non collantes sur une couche photosensible par irradiation à la façon dont on forme une image;
   (b) on met en contact la couche irradiée avec une couche de transfert, sur un support d'émulsion, non photosensible, et qui contient, dans son liant, au moins une poudre finement divisée ou bien au moins une poudre finement divisée et au moins un colorant en solution; et
   (c) les deux couches sont séparées,
   caractérisé en ce que:
   la couche de transfert comporte, sur sa face, non en contact avec le support, une couche superficielle rugueuse.

2. Procédé d'obtention d'images polychromes dans lequel:
   (a) on applique une couche photosensible sur un support, sur laquelle on peut obtenir des zones collantes et non collantes, par irradiation à la façon dont on forme une image;
   (b) on irradie, à la façon dont on forme une image, la couche photosensible;
   (c) on met en contact la couche irradiée, avec une couche de transfert, sur un support d'émulsion, non photosensible, et qui contient, dans son liant, au moins une poudre finement divisée ou bien au moins une poudre finement divisée et au moins un colorant en solution;
   (d) on sépare de nouveau le support avec la zone non adhérente de la couche de transfert; et
   (e) on recommence les étapes a-d,
   dans lequel, dans l'étape (a), on applique une nouvelle couche photosensible sur la couche photosensible comme décrit ci-dessus, caractérisé en ce que
   la couche de transfert comporte une couche superficielle rugueuse sur sa face non en contact avec le support.

3. Procédé selon la revendication 1 ou 2, caractérisé en ce que la couche superficielle rugueuse est principalement constituée de particules discrètes inertes.

4. Procédé selon la revendication 3, caractérisé en ce que les particules de la couche superficielle présentent un diamètre $\leqq 15$ µm.

5. Procédé selon la revendication 3 ou 4, caractérisé en ce que la densité superficielle des particules discrètes inertes est de 0,5-5000 particules/mm$^2$.

6. Procédé selon les revendications 1 à 5, caractérisé en ce que les particules de la couche superficielle sont constituées de $SiO_2$, d'$Al_2O_3$ et/ou d'homo-polymères et/ou copolymères d'éthylène, de propylène ou d'acide acrylique ou méthacrylique et de leurs dérivés.

7. Procédé selon les revendications 1 à 6, caractérisé en ce que la couche superficielle comprend une quantité inférieure ou égale à 80% en poids de polymère dont la résistance maximum à la traction est $\geqq$ 2N/mm$^2$.

8. Procédé selon les revendications 1 à 7, caractérisé en ce que la couche de transfert comprend 30 à 70% en poids de poudre finement divisée ou d'une combinaison de poudre finement divisée/colorant en solution.

9. Procédé selon l'une quelconque des revendications 1 à 8, caractérisé en ce que la couche de transfert comporte un polymère présentant une résistance maximum à la traction $\geqq$ 2N/mm$^2$.

10. Procédé selon l'une quelconque des revendications 1 à 9, caractérisé en ce que le support est constitué d'une matière compressible.

9

11.  Procédé selon l'une quelconque des revendications 1 à 10, caractérisé en ce qu'il comporte, en tant que couche photosensible tonable, une couche photopolymérisable contenant au moins un monomère photopolymérisable, un photoinitiateur et un liant.